# EUROPEAN PATENT APPLICATION

(11) **EP 1 553 579 A1**
(43) Date of publication of application: **13.07.2005**
(21) Application number: 03733431.5
(22) Date of filing: 16.06.2003
(51) Int. Cl.: G11B 7/26, C23C 14/04, C23C 14/50

(54) **METHOD OF DELIVERING SUBSTRATE TO FILM FORMING DEVICE FOR DISK-LIKE SUBSTRATE, MECHANISM FOR DELIVERING SUBSTRATE USED FOR THE METHOD, SUBSTRATE HOLDER, AND METHOD OF MANUFACTURING DISK-LIKE RECORDING MEDIUM USING THE METHOD**

(30) Priority: 20.06.2002 JP 2002180042
(71) Applicant: TDK Corporation, Chuo-ku, Tokyo 103-8272 (JP)
(72) Inventor: KOSHIKAWA, Masato, TDK Corporation, Chuo-ku, Tokyo 103-8272 (JP); WATANABE, Hideaki,2TDK Corporation, Chuo-ku, Tokyo 103-8272 (JP)
(74) Representative: Grünecker, Kinkeldey, Stockmair & Schwanhäusser Anwaltssozietät
(86) International application number: PCT/JP2003/007602
(87) International publication number: WO 2004/001738

(57) **Abstract**

A substrate delivering method is provided, with which a disk-shaped substrate or the like with no center hole provided can be held in the atmosphere for easy transfer to a sputtering device. A projection portion is provided at a central portion of either side of a disk-shaped substrate, and transport etc of the substrate is performed with the substrate being integrated with an outer mask and an inner mask that cover outer peripheral end and central portions of the substrate. A delivering mechanism holds the inner mask and the outer mask by a magnetic force, and holding of the inner mask and the outer mask by a magnetic force is simultaneously effected on the substrate holder side to which the substrate is to be delivered, with the magnetic force on the delivering mechanism side being reduced during delivery of the substrate.

## Description

### TECHNICAL FIELD

The present invention relates to a thin film forming device for forming a thin film on a disk-shaped substrate. More specifically, the present invention relates to a method of delivering to the device a disk-shaped substrate used in the device, and to a mechanism used in the method. Further, the present invention also relates to a so-called substrate holder used with the mechanism, and a disk-shaped recording medium manufacturing method for manufacturing a disk-shaped recording medium such as a so-called optical disk by using the mechanism.

### BACKGROUND ART

Examples of recording media manufactured by forming a thin film of various kinds on a disk-shaped substrate, particularly those having a disk-like configuration, include: optical disks including CD disks such as a CD, a CD-R, or a CD-RW, and DVD disks such as a DVD-ROM or a DVD-R; optical magnetic disks such as an MO or an MD; and various other types of disks. Those disks are manufactured by laminating a thin film on a substrate made of a polycarbonate material, for example, by various methods such as sputtering or spin coating.

In general, in a substrate serving as the base material of those disks, a through hole is already formed in the central portion thereof to facilitate disk handling when those disks are actually used as recording media. In the subsequent thin film formation steps, disk handling operations are usually performed using this center hole, including transporting of the substrate to and from a thin film forming device or the like, positioning of the substrate in the thin film forming device, and the like. However, during the film formation process, the existence of this center hole may, for example, cause a reduction in the thin film thickness or thin film distribution on the substrate. A commonly used solution to this problem is to cover the center hole with a cap or the like when performing film formation, thereby minimizing the influence that the center hole may exert on the film formation process.

During the manufacture of a DVD disk, for example, a thin film made of an ultraviolet curing resin, which is one of the films constituting the disk, is formed by spin coating. Specifically, first, a substrate is mounted on a rotatable table such that the center of the substrate coincides with the rotation center of the table. Accordingly, the substrate is positioned and fixed with respect to the table through such operations as using a rotation shaft that passes through the center hole, or placing a cap, which is fixed concentrically with respect to the rotation center of the table, over the center hole of the disk.

Subsequently, resin is successively supplied dropwise to the rotating disk from the vicinity of the center hole or an end portion of the cap toward the outer periphery of the disk. The resin thus supplied dropwise is dispersed due to the centrifugal force generated by the disk rotation, forming a resin thin film on the substrate surface. Note that the resin thin film thus obtained then undergoes steps such as irradiation of ultraviolet rays, thus providing a stable film structure.

In this case, the resin must be dropped at a position off the rotation center, leading to the occurrence of a film thickness distribution. In this regard, red laser light, which is currently commonly used for reading of a record, has a relatively long wavelength, hence keeping such a film thickness distribution within the permissible range. However, as blue laser light, which has a short wavelength, comes to be used in the near future to increase the recording density of optical disks, it becomes necessary to obtain a thin film with more uniform thickness.

As the means for solving the above-mentioned problem, that is, as the method for alleviating generation of the film thickness distribution during the above process using spin coating, the applicant of the present invention has proposed a manufacturing process using a substrate with no hole provided at the central portion thereof. In this manufacturing process, a through hole is formed at the central portion of the substrate after forming a thin film of various kinds thereon.

For instance, a metal thin film or the like used for a reflection film or the like is formed by sputtering. In this manufacturing process, a disk-shaped substrate is fixed and held onto the front side of a target within a vacuum container. Commonly, a given voltage is applied to the target and electric discharge thus takes place between the target and the substrate, generating plasma. The constituent chemical elements of the target on the target surface are sputtered with ions in the plasma, and the sputtered particles adhere onto the substrate surface, thus effecting film formation.

When forming a metal thin film by the above sputtering method, radiation heat from the plasma or the energy of ions entering the substrate causes an increase in the substrate temperature. The substrate undergoes thermal expansion or thermal deformation due to this temperature rise. During the film formation process, the outer peripheral portion of the substrate is substantially fixed in position by a so-called outer mask. Therefore, the thermal expansion or the like of the substrate is restricted by the outer mask, which may cause warping such that the greatest deformation takes place at the central portion of the substrate.

Normally, the rear side of the substrate is held in intimate contact with the substrate holder and heat is released through the substrate holder to some extent, so that large accumulation of heat does not take place and it is unlikely that such warping becomes a problem. Depending on the film formation condition, however, there may be cases where the heat release cannot keep pace with the heat generation, and the central portion of the substrate separates from the substrate holder that is holding the substrate due to the resulting warping, that is, from the holder to which heat is to be transferred. In this case, the amount of heat release decreases, causing the substrate temperature to rise further and thus increasing the deformation of the substrate.

One way to overcome this problem would be to provide a mechanism for forcibly pressing the central portion of the substrate, where the largest deformation tends to take place, onto the substrate holder. This method can be implemented relatively easily when using the conventional substrate having a through hole at its central portion, by using a so-called inner mask that covers the central portion.

For the purpose of improving the thickness uniformity of a thin film formed by spin coating, the inventor of the present invention has devised and proposed a novel substrate chucking method for chucking a substrate having no through hole at its central portion inside a sputtering device. In addition, to automate the series of film formation steps, the inventor of the present invention has also proposed a substrate transporting mechanism or the like capable of performing reliable transfer or the like of not only the substrate but also the outer mask that covers the outer peripheral portion of the substrate. As described above, however, a film formation process with a sputtering device by using such a mechanism involves a problem in that the central portion of the substrate may undergo warping, and some solution to this problem will have to be implemented.

### DISCLOSURE OF THE INVENTION

A substrate delivering method according to the present invention has been devised in view of the above-described requirement, and therefore an object of the present invention is to make it possible to reliably maintain the relative positional relation between the outer mask etc and the substrate during transport of a substrate. Further, another object of the present invention is to provide a substrate delivering mechanism for a thin film forming device such as a sputtering device embodying the above delivering method, and a disk-shaped recording medium manufacturing method using this device.

To attain the above objects, according to the present invention, there is provided a substrate delivering method for delivering a disk-shaped substrate together with an inner mask and an outer mask to a substrate holder, the substrate having a projection portion at a center of its back surface, the inner mask having a magnetic property and being adapted to cover a central surface portion of the substrate, the outer mask having a magnetic property and being adapted to cover an outer peripheral surface portion of the substrate, characterized by including: fixing and holding respective surfaces of the inner mask and the outer mask onto a mask holding surface of a transport arm in advance by causing magnetic forces to be exerted onto the inner mask and the outer mask from predetermined positions on the mask holding surface, and placing the substrate on the inner mask and the outer mask which are held on the mask holding surface; opposing the substrate holder to the mask holding surface of the transport arm on which the inner mask, the outer mask, and the substrate are held; inserting the projection portion, which is provided at the center of the substrate back surface, into a recess provided at a center of the substrate holder and, at substantially the same time, causing magnets provided inside the substrate holder to exert magnetic forces onto the inner mask and the outer mask; reducing the magnetic forces exerted onto the inner mask and the outer mask from the transport arm; and delivering the substrate to the substrate holder by fixing and holding respective back surfaces of the inner mask and the outer mask onto the substrate holder by the magnetic forces exerted from the substrate holder.

In the above-described substrate delivering method, it is preferable that the substrate be fixed onto the outer mask by in-mask substrate-holding means provided in the outer mask, and that the delivering of the substrate be performed with the substrate and the outer mask being integrated together. Further, it is preferable that the magnet provided in the substrate holder be arranged in a substantially central portion of the substrate holder and a vicinity thereof and at a position substantially corresponding to the outer mask.

Further, to attain the aforementioned objects, according to the present invention, there is provided a substrate holder for holding, during film formation on a substantially disk-shaped substrate having a projection portion at a center of its back surface, the substrate, an outer mask adapted to cover an outer peripheral surface portion of the substrate, and an inner mask adapted to cover a central surface portion of the substrate, including: a substantially annular substrate receiving surface adapted to receive the back surface of the substrate; a cylindrical recess provided at a center portion of the substrate receiving surface; an inner-mask fixing magnet received in the recess; and an outer-mask receiving surface provided in a periphery of the substrate receiving surface and depressed with respect to the substrate receiving surface.

In the above-described substrate holder, it is preferable that the inner-mask fixing magnet have a substantially cylindrical shape with a hole having a diameter large enough to receive the projection portion on the back surface of the substrate. Further, it is preferable that the inner-mask fixing magnet be fixed onto an arbitrary portion of the recess through an elastic member.

Further, to attain the above-mentioned objects, according to the present invention, there is provided a substrate delivering mechanism which holds a substantially disk-shaped substrate together with an outer mask and an inner mask, the substrate having a projection portion at a central portion of its back surface, the outer mask being adapted to cover an outer peripheral portion of the substrate, the inner mask being adapted to cover a central portion of the substrate, and which transfers the substrate, the inner mask, and the outer mask to a substrate holding mechanism, including: an inner-mask receiving surface for supporting the inner mask; a magnet for inner mask which is arranged underneath the inner-mask receiving surface and capable of moving toward and away from the inner-mask receiving surface; an outer-mask receiving surface for supporting the outer mask; and a magnet for outer mask which is arranged underneath the outer-mask receiving surface and capable of moving toward and away from the outer-mask receiving surface, the substrate delivering mechanism being characterized in that the substrate is held in a predetermined position by fixing and holding the inner mask and the outer mask in predetermined positions by a magnetic force exerted by the magnet for inner mask and a magnetic force exerted by the magnet for outer mask, respectively, and that transfer of the inner mask and the outer mask can be effected by moving the magnet for inner mask and the magnet for outer mask away from the inner-mask receiving surface and the outer-mask receiving surface, respectively.

In the above-described substrate delivering mechanism, it is preferable that the inner-mask receiving surface and the outer-mask receiving surface lie on the same plane.

Further, to attain the aforementioned objects, according to the present invention, there is provided a disk-shaped recording medium manufacturing method using a substantially disk-shaped substrate, including: fixing and holding respective surfaces of an inner mask and an outer mask onto a mask holding surface of a substrate transport arm by a magnetic force, the inner mask being adapted to cover a central surface portion of the substrate, the outer mask being adapted to cover an outer peripheral portion of the substrate, and supporting a predetermined surface portion of the substrate by respective back surfaces of the inner mask and the outer mask; opposing a substrate holder to the mask holding surface of the transport arm on which the inner mask, the outer mask, and the substrate are held; causing a magnetic force to be exerted from the substrate holder onto the inner mask and the outer mask; reducing the magnetic force exerted from the transport arm onto the inner mask and the outer mask; sandwiching the substrate by the inner mask and the outer mask by fixing and holding the respective back surfaces of the inner mask and the outer mask onto the substrate holder by the magnetic force exerted from the substrate holder; transporting the substrate holder, which is holding the substrate, the inner mask, and the outer mask, to a thin film formation position in a thin film forming device; and forming a thin film on the substrate.

In the above-described manufacturing method, it is preferable that the transporting of the substrate holder from the substrate transport arm to the thin film forming device be performed in a state in which the substrate and a mask that covers an outer peripheral end portion of a film formation surface of the substrate are integrated together by in-mask substrate-fixing means provided in the mask. Further, it is preferable that the substrate have a projection portion on its back surface, and the substrate holder has a receiving hole which receives the projection portion.

### BRIEF DESCRIPTION OF THE DRAWINGS

Fig. 1 relates to a substrate delivering mechanism according to a first embodiment of the present invention, schematically illustrating the cross-sectional construction of a substrate holder that is holding a substrate and a mask.
Fig. 2 schematically illustrates the cross-sectional construction of an atmosphere-side transport arm serving as the substrate delivering mechanism according to the first embodiment of the present invention.
Fig. 3 illustrates a substrate delivering method according to the present invention.
Fig. 4 illustrates the substrate delivering method according to the present invention.
Fig. 5 illustrates the substrate delivering method according to the present invention.
Fig. 6 illustrates the substrate delivering method according to the present invention.
Fig. 7 schematically illustrates the cross-sectional construction of a substrate holder holding the substrate and the mask according to a second embodiment of the present invention.

### BEST MODE FOR CARRYING OUT THE INVENTION

### (First Embodiment)

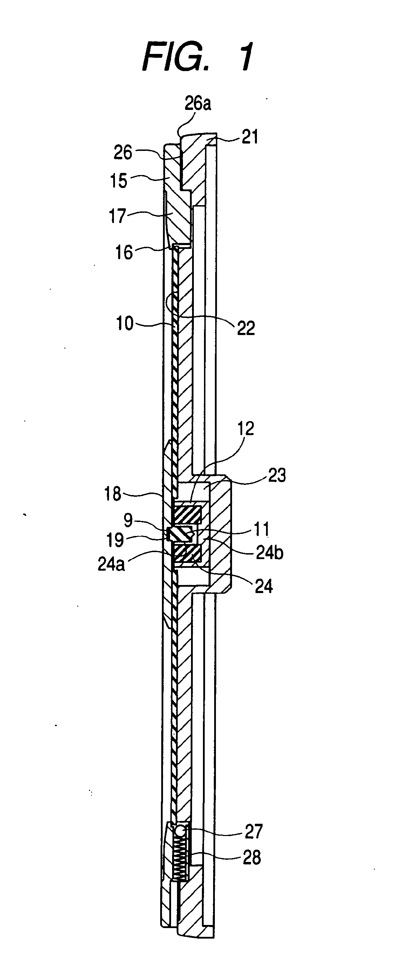

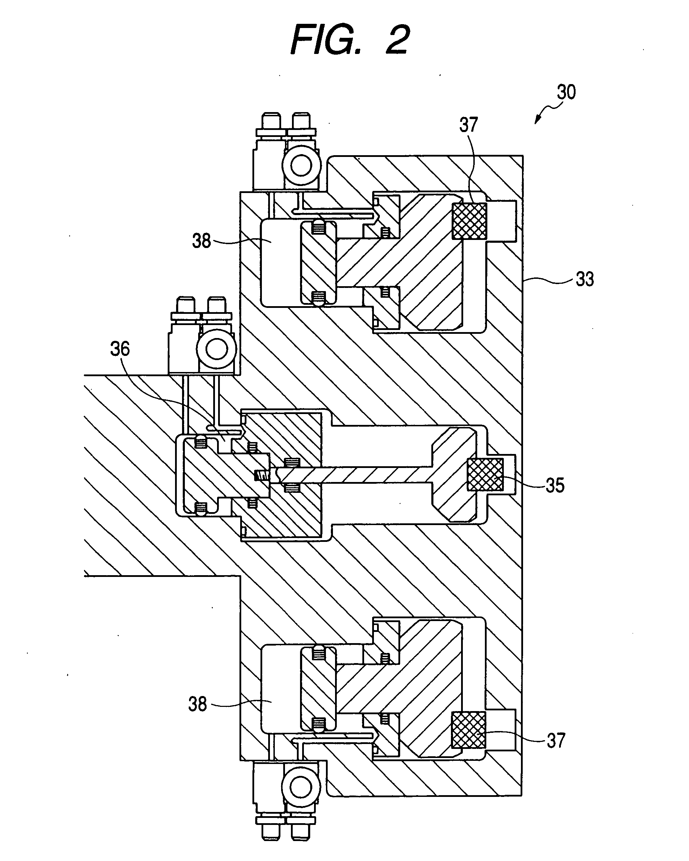

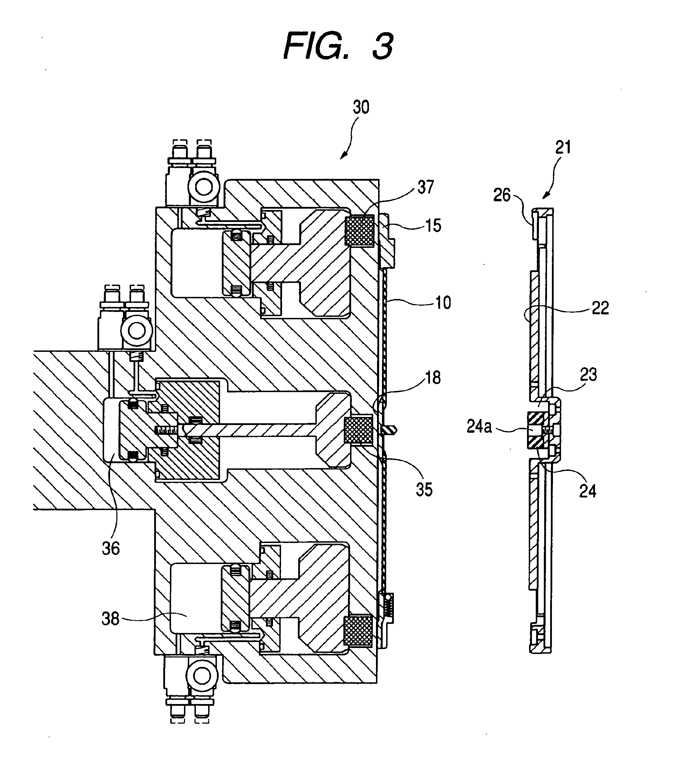

Hereinbelow, a substrate holder, a substrate delivering mechanism, and the like according to a first embodiment of the present invention are described in detail. Fig. 1 is a schematic cross-sectional view showing the substrate holder, which can be held together with the substrate by this delivering mechanism and actually holds the substrate during the film formation process with a sputtering device or the like, the substrate, an outer mask, and an inner mask that are held by the substrate holder. Further, Fig. 2 is a schematic cross-sectional view of an atmosphere-side transport arm having the substrate delivering mechanism, which is arranged substantially facing the substrate holder that is holding the substrate and delivers the substrate and the masks between the substrate delivering mechanism and the substrate holder. Further, Figs. 3 through 6 are schematic cross-sectional views each illustrating how delivery of the substrate is effected according to the above-described construction.

A substrate 10 used in the present invention is formed in a substantially disk-like shape and has a first projection portion 9 formed at the central portion of its film formation surface and a second projection portion 11 formed at the central portion of the rear side of the film formation surface. The projection portions each have a substantially columnar shape whose axial center coincides with the center of the substrate. A substrate holder 21, which is held by a vacuum-side transport arm or the like (not shown) of a sputtering device, is composed of a substantially annular substrate-receiving portion 22 adapted to receive the back side of the substrate, an outer-mask receiving portion 26 arranged in the outer periphery thereof and depressed with respect to the substrate receiving portion, and a recess 23 provided at the central portion of the substrate holder to receive an inner-mask fixing magnet 24.

The inner-mask fixing magnet 24 has a cylindrical configuration with an opening 24a provided on the substrate back surface side and a bottom portion 24b provided on the side opposite therefrom. The magnet 24 is arranged with an end portion of the opening 24a facing the substrate back surface side such that the second projection portion 11 on the substrate back surface is fitted in the opening 24a. Further, the magnet 24 has a screw hole (not shown) formed in the bottom surface 24b constituting the other end portion thereof. The magnet 24 is fixed onto the bottom surface of the recess 23 of the substrate holder 21 by using this screw hole. It is to be noted that the above-described structure is employed for the purpose of fixing the inner-mask fixing magnet 24 onto the bottom surface of the recess 23 with sufficient strength and precision. Hence, as long as this requirement can be met, it is also possible to simply affix the cylindrical magnet onto the bottom surface of the recess with an adhesive or the like.

An inner mask 18 has a substantially disk-like configuration whose height from the surface in intimate contact with the substrate 10 surface decreases with increasing proximity to its end portions. The inner mask 18 has a receiving recess 19, which receives the first projection portion 9 of the substrate surface, provided at the center of its surface that is in intimate contact with the substrate 10. Fitting the first projection portion 9 into the receiving recess 19 effects the positioning between the substrate 10 and the inner mask. The inner mask 18, which is formed of a magnetic material, comes into intimate contact with the substrate surface while substantially pressing the substrate 10 against the magnet 24 by means of the magnetic force of the inner-mask fixing magnet 24 arranged on the back surface of the substrate 10. Since the central portion of the substrate is thus urged toward the substrate holder 21 side, warping of the substrate 10 can be suppressed even in situations where the substrate 10 is liable to undergo thermal expansion during the sputtering process.

It is to be noted that in this embodiment, as shown in Fig. 1, there is provided an annular groove 12, into which the substrate-side end portion of the inner-mask fixing magnet 24 is fitted, in the periphery of the second projection portion 9 on the substrate back surface in order to keep the relative positional relation between the substrate 10 and the inner-mask fixing magnet 24 constant. That is, the height of the inner-mask fixing magnet 24 and the depth of the recess 23 are so adjusted that the substrate-side end portion of the inner-mask fixing magnet 24 can be fitted in the annular groove 12 but does not reach the bottom surface of the recess 23 provided in the substrate holder 21.

The above-described construction enables a reduction in substrate thickness at the central portion, providing such effects as greater magnetic force exerted on the inner mask by the inner-mask fixing magnet 24 and also reduced deformation force acting on the central portion of the substrate 10 upon thermal deformation. It is not particularly necessary to provide the annular groove 12, however, provided that the warping of the substrate central portion can be reliably suppressed by the inner mask 18 and the inner-mask fixing magnet 24.

An outer mask 15 has a ring-shaped outer-mask main body 17 whose inner diameter is larger than the outer diameter of the substrate, and an outer mask flange portion 16 projecting toward the inner peripheral side from one end face of the outer-mask main body 17 and adapted to cover the outer peripheral end portion of the substrate 10. Further, provided inside the outer-mask main body 17 is an in-mask ball plunger 27. The in-mask ball plunger 27, which is arranged facing the inner peripheral surface of the ring-shaped outer mask 15, serves as substrate holding means for sandwiching the substrate 10 with the outer mask flange portion 16 and for holding and fixing the substrate in position with respect to the outer mask 15.

The outer mask flange portion 16 must have a width which provides a sufficient distance between the outer-mask main body 17 supporting it and the substrate 10 to prevent abnormal electric discharge from occurring therebetween during film formation by sputtering. Further, to minimize its influence on the electric field during film formation, the outer mask flange portion 16 is provided with a tapered portion, sloping toward the other end face thereof with increasing proximity to its inner peripheral end portion.

Further, a minute gap of a predetermined value or less must be provided between the inner peripheral end portion of the outer mask flange portion 16 and the surface of the substrate 10 to prevent the occurrence of abnormal electric discharge and contact therebetween during film formation by sputtering. Therefore, in supporting the outer mask 15 by the outer-mask receiving portion 26, the thickness of the outer-mask main body 17 and the thickness of the outer mask flange portion 16, the method of supporting the outer mask 15, etc must be determined according to the electric discharge conditions to satisfy the above requirement. It is to be noted that the conditions and the like regarding the configuration of the mask flange portion also apply to the outer peripheral end portion of the inner mask 18.

The in-mask ball plunger 27 serving as in-mask substrate-fixing means urges the substrate 10 toward the outer mask 15 by an in-mask spring 28 such that the center of the substrate 10 coincides with that of the outer mask 15. At the same time, the in-mask ball plunger 27 sandwiches the end portion of the substrate 10 with the outer mask flange portion 16, thus keeping the relative positional relation between the outer mask 15 and the substrate 10 constant at all times.

In this embodiment, the outer mask 15 is held and fixed in intimate contact with the outer-mask receiving portion 26 by the magnetic force generated by an outer-mask fixing magnet (not shown) located in the outer-mask receiving portion 26. With the outer mask 15 thus being held in intimate contact with the substrate holder 21 by means of the above-described magnet, the back surface of the substrate 10 is held in intimate contact with a substantially annular flat surface formed as the substrate receiving portion 22. It is to be noted that the outer-mask receiving portion 26 includes a region of precise flatness formed in the vicinity of its outer periphery. This region serves as ah outer-mask receiving surface 26a which protrudes slightly toward the outer mask 15 side with respect to other portions of the outer-mask receiving portion 26, and the outer-mask receiving surface 26a actually supports the outer mask 15. This construction makes it possible to hold the outer mask 15 in position with good precision while reducing the area which requires high-precision machining.

As shown in Fig. 2, an atmosphere-side transport arm 30 serving as a substrate delivering mechanism has a substantially flat mask-receiving surface 33, a magnet for inner mask 35 and a magnet for outer mask 37 which are arranged underneath the mask receiving surface and capable of moving relative to the mask receiving surface, and an air cylinder 36 for the outer mask and an air cylinder for inner mask 38 which are capable of moving the magnets 35 and 37, respectively, toward and away from the mask receiving surface 33. In this embodiment, the upper end surfaces (the side opposite from the substrate holder side) of the inner mask 18 and the outer mask 15 lie on the same plane when those masks are integrated together with the substrate 10. Accordingly, by keeping the mask receiving surface 33 substantially planar, it is possible to hold the substrate and the like in a stable manner.

The magnet for inner mask 35 is arranged at a position corresponding to the substantially central portion of the mask receiving surface 33. With the magnet for inner mask 35 taken as the center position, the magnet for outer mask 37 is arranged at a position substantially corresponding to the outer-mask main body 17 of the substantially ring-shaped outer mask 15. It is to be noted that various positional arrangements may be adopted for the magnet for outer mask 37, such as providing a pair of magnets 37 at symmetrical positions, providing a plurality of magnets 37 radially, or adopting a substantially annular arrangement, with respect to the magnet for inner mask 35 taken as the center.

Description is now made on the operation for delivering the substrate 10, which is held by the atmosphere-side transport arm 30, to the substrate holder 21. It is to be noted that, in transferring the substrate 10 in the present invention, the positional relation between the substrate 10 and the outer mask 15 is determined by the action of the in-mask ball plunger 27, and they are transferred integrally at all times. First, as shown in Fig. 3, the substrate holder 21 that is not holding the substrate and the like, and the atmosphere-side transport arm 30 holding the outer mask 15 on the mask receiving surface 33 by the action of the magnet 35, are arranged to face each other. It is to be noted that for ease of understanding, the vacuum-side transport arm, which supports the substrate holder and transfers it into a vacuum device, is omitted from the drawing.

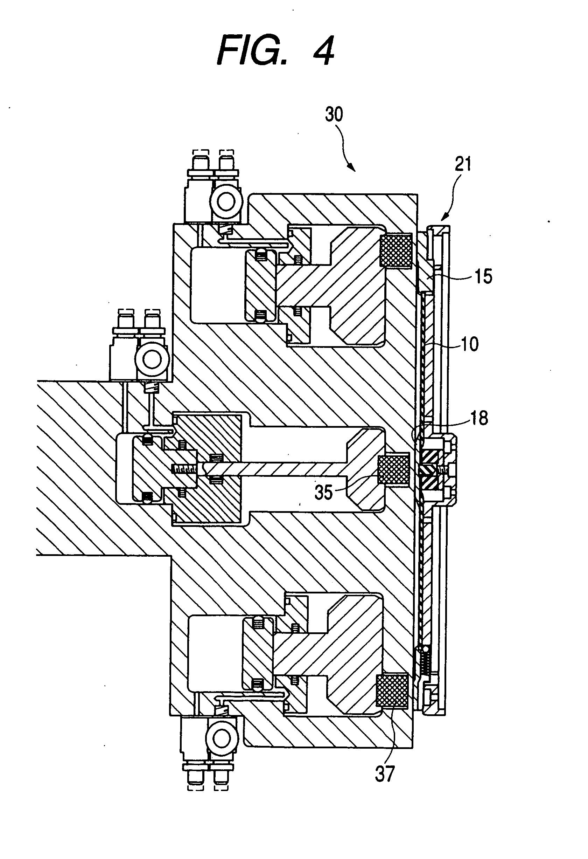

In the above state, the atmosphere-side transport arm 30 approaches the substrate holder 21, stopping at a predetermined distance from the substrate holder 21. This state is shown in Fig. 4. At this time, the second projection portion 11 of the substrate is inserted into the central recess of the inner-mask fixing magnet 24 arranged in the substrate holder 21, with the substrate-side end portion of the inner-mask fixing magnet 24 being fitted in the annular recess 12 on the substrate back surface.

In this state as well, a magnetic force is exerted onto the inner mask 18 from the inner-mask fixing magnet 24, and a magnetic force is exerted onto the outer mask 15 from the outer-mask fixing magnet (not shown). However, those magnetic forces are overcome by the magnetic forces exerted onto the inner mask 18 and the outer mask 15 from the magnet for inner mask 35 and the magnet for outer mask 37, respectively, of the atmosphere-side transport arm 30. Hence, the inner mask 18 and the outer mask 15 remain held on the mask receiving surface 33.

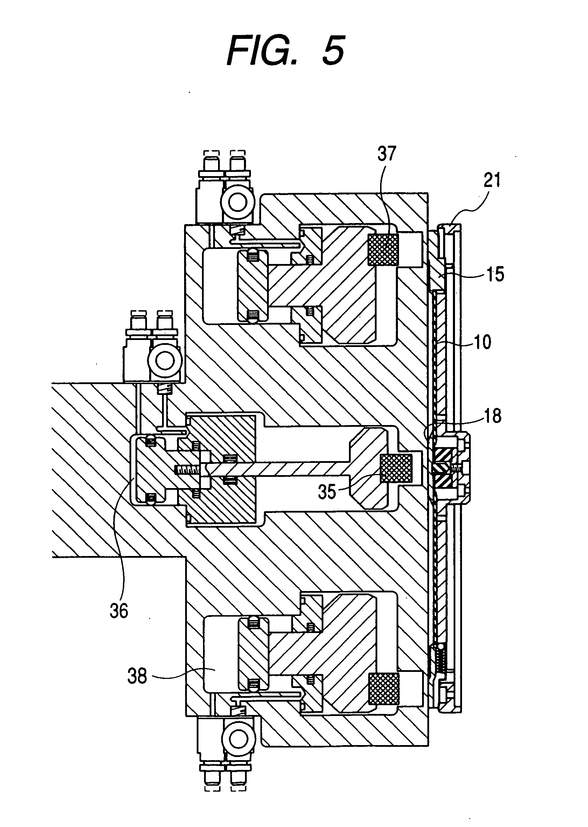

Subsequently, as shown in Fig. 5, the magnet for inner mask 35 and the magnet for outer mask 37 are separated from the substrate receiving surface 33 substantially simultaneously by the air cylinder for inner mask 36 and the air cylinder for outer mask 38, respectively. With this operation, the magnetic forces exerted on the inner mask 18 and the outer mask 15 by the magnet for inner mask 35 and the magnet for outer mask 37, respectively, decrease and the magnetic forces exerted from the substrate holder 21 side keep the respective masks held in position.

The inner-mask fixing magnet 24 and the outer-mask fixing magnet (not shown) are arranged at positions substantially corresponding to the magnet for inner mask 35 and the magnet for outer mask 37, respectively, on the atmosphere-side transport arm 30 side. Therefore, the holding positions and attitudes or the like of the inner and outer masks 15 and 18 basically do not change even through those magnets, which are previously held in position by the magnetic forces exerted from the atmosphere-side transport arm 30, are now held in position by the magnetic forces exerted from the substrate holder 21 side.

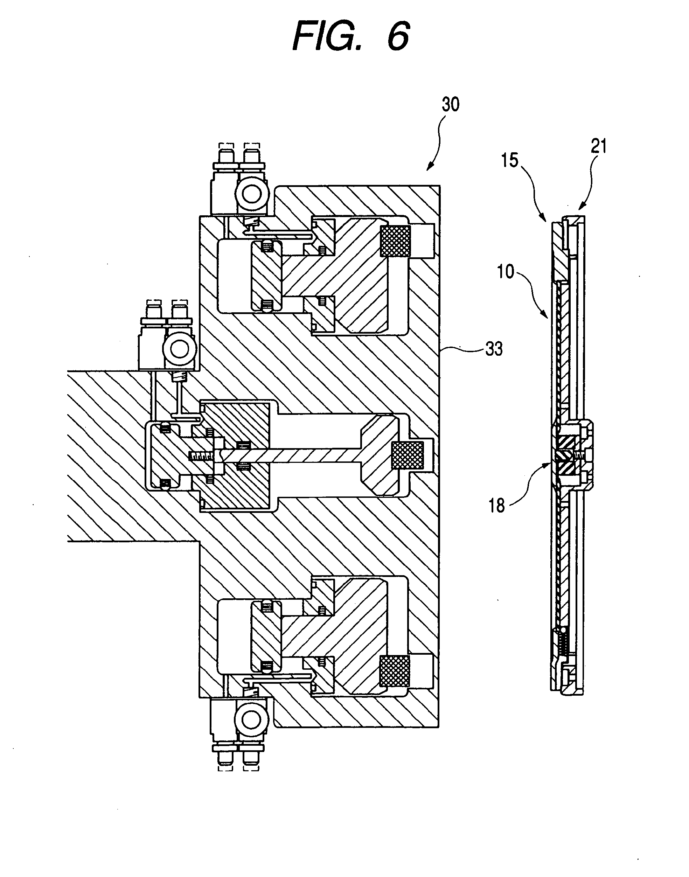

Thereafter, as shown in Fig. 6, the atmosphere-side transport arm 30 retracts, and the substrate holder 21 that is holding the substrate 10 and the mask 15 is transported to the sputtering device by the vacuum side transport arm (not shown), thus executing the film formation process. After the film formation process, the substrate holder 21 holding the substrate 10 that has undergone the film formation process returns to the position where the substrate holder 21 faces the atmosphere-side transport arm 30. Then, delivery of the substrate 10 and the like from the vacuum-side transport arm to the atmosphere-side transport arm 30 is performed through a procedure reverse to the delivery of the substrate 10 described above.

### (Second Embodiment)

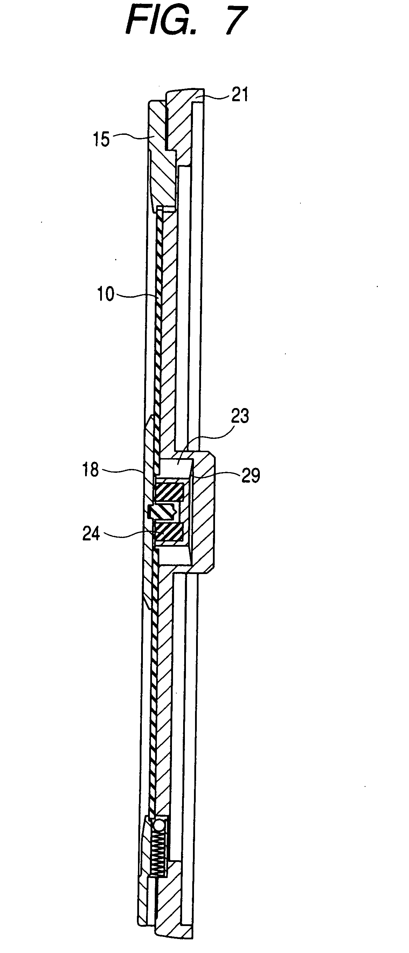

Fig. 7 is a schematic cross-sectional view of a substrate holder according to a second embodiment of the present invention, and the substrate, the outer mask, and the inner mask that are being held by the holder. The substrate holder can be held together with the substrate by the delivering mechanism according to the present invention and actually holds the substrate during film formation with the sputtering device or the like. It is to be noted that the construction of this embodiment except the substrate delivering mechanism is virtually unchanged from that of the first embodiment, and description thereof is thus omitted here.

The substrate holder of this embodiment is different from that of the first embodiment only in that an elastic member is provided on the bottom surface of the magnet 24. Hence, the following description focuses solely on this point. In the first embodiment, the magnet 24 has the screw hole or the like (not shown) on the bottom surface 24b, and the magnet 24 is fixed onto the bottom surface of the recess 23 of the substrate holder 21 by using this screw hole or the like. Therefore, cases may occur in which, for example, due to the mounting precision of the magnet 24 and the thickness of the substrate 10, an end portion of the magnet 24 cannot come into contact with the substrate 10 back surface or the bottom surface of the annular groove 12, making it impossible for the magnet 24 to exert a sufficient magnetic force onto the inner mask 18.

In the second embodiment, in contrast, the magnet 24 is fixed onto the bottom surface of the recess 23 with the elastic member 29 being interposed therebetween. The elastic member 29 enables slight movement of the magnet 24 in the direction of the substrate so that the end portion of the magnet 24 contacts the substrate 10 back surface or the like at all times, making it possible to exert onto the inner mask 18 the maximum possible magnetic force the design will allow. While in this embodiment a leaf spring is used as the elastic member 29, a rubber sheet or the like may also be used. Further, the arrangement position of the elastic member is not limited to the bottom portion of the magnet 24 as shown in Fig. 7, and it may be arranged on the side surface or the like of the magnet 24. In this case, any additional structure will suffice which acts to press the magnet onto the bottom surface side of the recess 23 while permitting slight movement of the magnet toward the substrate side.

By adopting the above-described construction, mounting of the substrate 10 to the substrate holder 21, and attaching of the outer mask 15 and the inner mask 18 to those members can be performed with ease and reliability even when using a substrate having no center hole. Further, the distance between the inner peripheral end portion of the outer mask and the substrate surface can be readily set to a predetermined value, making it possible to reduce the occurrence of abnormal electric discharge or the like.

While in the above embodiments the inner mask 18 consists of a single magnetic member, the inner mask 18 may contain a magnetic member covered with resin or the like in its inside. Further, in this embodiment, the upper end surfaces of the inner mask 18 and the outer mask 15 lie on the same plane, and the mask receiving surface 33 consists of a flat surface. However, a construction is also possible in which, for example, the mask receiving surface is provided with recesses corresponding to the respective masks, and the masks are held by those recesses, providing more reliable positioning of the masks. Alternatively, a construction is also possible in which the upper end surfaces of the inner mask and the upper mask lie on different planes and the mask receiving surface is composed of an inner-mask receiving surface and an outer-mask receiving surface, or it is also possible to provide recesses corresponding to those masks.

Referring to the drawings, the recess 23 is formed so as to maintain a sufficient space from the outer periphery of the inner-mask fixing magnet 24. However, from the viewpoint of more effectively preventing the temperature of the substrate from rising during film formation, it is desirable to minimize this space to secure a large area in intimate contact with the substrate back surface. Further, while in this embodiment the region whose flatness is secured is formed in the vicinity of the outer periphery of the mask receiving surface 33, the position where this region is formed is not limited to the vicinity of the outer periphery; it may be formed in an arbitrary manner according to the specific machining or mask supporting requirements, or it may not be provided at all.

Further, in the drawings, the outer diameters of the magnet for inner mask 35 and the magnet for outer mask 37 are set to the same dimension. However, it is preferable that the size or kind of those magnets be selected as appropriate according to the magnitudes of magnet forces required at respective positions. Further, the requisite magnetic force may be adjusted by varying the drive range of the air cylinders with respect to the magnets. Further, in this embodiment, for the ease of handling, the simplicity of the device construction, etc., air cylinders that are controlled between only two positions are used to drive the respective magnets. However, when, for instance, it is necessary to set a plurality of magnet stop positions to enable stepwise adjustment of the magnetic force, it is also possible to use a drive apparatus such as an air cylinder which provides a plurality of stop positions or a stepping motor.

Further, in the above embodiments, the substrate used has projection portions on its surface, with the receiving recesses adapted to receive those projection portions being provided to the inner mask. However, it is not necessary to provide those recesses when the substrate surface is flat. Further, when, for instance, a positioning depression is provided at the center of the substrate, a projection portion corresponding to the depression may be provided on the back surface of the mask, thus effecting positioning.

Further, in the above embodiments, the in-mask ball plungers 27 provided in the mask main body 17 are arranged at equal intervals such that the direction of action of the in-mask ball plungers 27 coincides with the central portion of the ring-shaped mask main body 17. However, the number of the in-mask ball plungers 27 is not particularly limited as long as the substrate 10 can be fixed and supported to the substantially center of the ring shape; for example, even only one ball plunger and positioning projection portion may suffice. While the ball plunger is used to fix and hold the substrate 10 in position, this should not be construed restrictively; any structure capable of providing the same action may be used.

While in the foregoing description the sputtering device is exemplified as a thin film forming device to which the present invention is applicable, the applications of the present invention are not limited to this; it is also possible to apply the present invention to a variety of thin film forming devices such as a vapor deposition device or a CVD device. Further, the use of the present invention is not confined to the manufacture of an optical disk or the like; it is also applicable to the manufacturing process of any disk-shaped component which involves the step of removing its central portion at a later stage of the process, such as a hard disk.

When implemented, the present invention makes it possible to stably bring a disk-shaped substrate with no center hole into intimate contact with a holder, thereby holding the substrate in position. As a result, it becomes possible to effect thin film formation on a disk-shaped substrate with, no center hole not only for the film formation process by spin coating but also for the film formation process by sputtering, making it possible to obtain a thin film with higher uniformity of its film thickness and film property.

Further, when implemented, the present invention makes it possible to reliably hold and transfer the substrate in the atmosphere and to perform delivery or the like of the substrate to and from the sputtering device with safety, thereby facilitating automation of the series of film formation steps. Further, the substrate, the inner mask, and the outer mask are delivered to and from the sputtering device while fixing the positional relation among those members, making it possible to easily suppress the occurrence of abnormal electric discharge due to the masks or other adverse influences or the like the masks may exert on the film thickness distribution or the like.

## Claims

1. A substrate delivering method for delivering a disk-shaped substrate together with an inner mask and an outer mask to a substrate holder, the substrate having a projection portion at a center of its back surface, the inner mask having a magnetic property and being adapted to cover a central surface portion of the substrate, the outer mask having a magnetic property and being adapted to cover an outer peripheral surface portion of the substrate, comprising:
fixing and holding respective surfaces of the inner mask and the outer mask onto a mask holding surface of a transport arm in advance by causing magnetic forces to be exerted onto the inner mask and the outer mask from predetermined positions on the mask holding surface, and placing the substrate on the inner mask and the outer mask which are held on the mask holding surface;
opposing the substrate holder to the mask holding surface of the transport arm on which the inner mask, the outer mask, and the substrate are held;
inserting the projection portion, which is provided at the center of the substrate back surface, into a recess provided at a center of the substrate holder and, at substantially the same time, causing magnets provided inside the substrate holder to exert magnetic forces onto the inner mask and the outer mask;
reducing the magnetic forces exerted onto the inner mask and the outer mask from the transport arm; and
delivering the substrate to the substrate holder by fixing and holding respective back surfaces of the inner mask and the outer mask onto the substrate holder by the magnetic forces exerted from the substrate holder.

2. A substrate delivering method according to Claim 1, wherein the substrate is fixed onto the outer mask by in-mask substrate-holding means provided in the outer mask, and that the delivering of the substrate is performed with the substrate and the outer mask being integrated together.

3. A substrate delivering method according to Claim 1, wherein the magnets provided in the substrate holder are arranged in a substantially central portion of the substrate holder and a vicinity thereof and at a position substantially corresponding to the outer mask.

4. A substrate holder for holding, during film formation on a substantially disk-shaped substrate having a projection portion at a center of its back surface, the substrate, an outer mask adapted to cover an outer peripheral surface portion of the substrate, and an inner mask adapted to cover a central surface portion of the substrate, comprising:
a substantially annular substrate receiving surface adapted to receive the back surface of the substrate;
a cylindrical recess provided at a center portion of the substrate receiving surface;
an inner-mask fixing magnet received in the recess; and
an outer-mask receiving surface provided in a periphery of the substrate receiving surface and depressed with respect to the substrate receiving surface.

5. A substrate holder according to Claim 4, wherein the inner-mask fixing magnet has a substantially cylindrical shape with a hole having a diameter large enough to receive the projection portion on the back surface of the substrate.

6. A substrate holder according to Claim 4, wherein the inner-mask fixing magnet is fixed onto an arbitrary portion of the recess through an elastic member.

7. A substrate delivering mechanism which holds a substantially disk-shaped substrate together with an outer mask and an inner mask, the substrate having a projection portion at a central portion of its back surface, the outer mask being adapted to cover an outer peripheral portion of the substrate, the inner mask being adapted to cover a central portion of the substrate, and which transfers the substrate, the inner mask, and the outer mask to a substrate holding mechanism, comprising:
an inner-mask receiving surface for supporting the inner mask;
a magnet for inner mask which is arranged underneath the mask receiving surface and capable of moving toward and away from the inner-mask receiving surface;
an outer-mask receiving surface for supporting the outer mask; and
a magnet for outer mask which is arranged underneath the mask receiving surface and capable of moving toward and away from the outer-mask receiving surface,
wherein the substrate is held in a predetermined position by fixing and holding the inner mask and the outer mask in predetermined positions by a magnetic force exerted by the magnet for inner mask and a magnetic force exerted by the magnet for outer mask, respectively, and transfer of the inner mask and the outer mask can be effected by moving the magnet for inner mask and the magnet for outer mask away from the inner-mask receiving surface and the outer-mask receiving surface, respectively.

8. A substrate delivering mechanism according to Claim 7, wherein the inner-mask receiving surface and the outer-mask receiving surface lie on the same plane.

9. A disk-shaped recording medium manufacturing method using a substantially disk-shaped substrate, comprising:
fixing and holding respective surfaces of an inner mask and an outer mask onto a mask holding surface of a substrate transport arm by a magnetic force, the inner mask being adapted to cover a central surface portion of the substrate, the outer mask being adapted to cover an outer peripheral portion of the substrate, and supporting a predetermined surface portion of the substrate by respective back surfaces of the inner mask and the outer mask;
opposing a substrate holder to the mask holding surface of the transport arm on which the inner mask, the outer mask, and the substrate are held;
causing a magnetic force to be exerted from the substrate holder onto the inner mask and the outer mask;
reducing the magnetic force exerted from the transport arm onto the inner mask and the outer mask;
sandwiching the substrate by the inner mask and the outer mask by fixing and holding the respective back surfaces of the inner mask and the outer mask onto the substrate holder by the magnetic force exerted from the substrate holder;
transporting the substrate holder, which is holding the substrate, the inner mask, and the outer mask, to a thin film formation position in a thin film forming device; and
forming a thin film on the substrate.

10. A disk-shaped recording medium manufacturing method according to Claim 9, wherein the transporting of the substrate holder from the substrate transport arm to the thin film forming device is performed in a state in which the substrate and a mask that covers an outer peripheral end portion of a film formation surface of the substrate are integrated together by in-mask substrate-fixing means provided in the mask.

11. A disk-shaped recording medium manufacturing method according to Claim 9, wherein the substrate has a projection portion on its back surface, and the substrate holder has a receiving hole which receives the projection portion.
